# EUROPEAN PATENT APPLICATION

(11) **EP 4 790 745 A1**
(43) Date of publication of application: **12.08.2026**
(21) Application number: 25156995.0
(22) Date of filing: 11.02.2025
(51) Int. Cl.: H01L 21/67, H01H 29/02, H01L 21/683, H10H 29/02, B65G 47/91

(54) **STAGE FOR DIE PLACEMENT**

(71) Applicant: ASML Netherlands B.V., 5500 AH Veldhoven (NL)
(72) Inventor: SEIJGER, Olav, Johannes, 5500 AH Veldhoven (NL)
(74) Representative: ASML Netherlands B.V.

(57) **Abstract**

A stage for die placement comprises: a support member; a movable member that is movable relative to the support member, wherein the movable member is configured to hold at least one die; and an actuator configured, on actuation, to move the movable member relative to the support member so as to flip the die and move the die along a die path to place the die on an acceptor substrate, wherein the stage is arranged such that the die path extends further in a direction perpendicular to a plane of the acceptor substrate than in a direction parallel to the plane of the acceptor substrate.

## Description

### TECHNICAL FIELD

The present disclosure relates generally to a stage for die placement, a bonding tool, and a method for die placement.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in die placement and alignment (e.g., improvements in heterogeneous integration) lead to improvements in IC manufacturing and integration abilities.

### SUMMARY

According to an embodiment, there is provided a stage for die placement comprising: a support member; a movable member that is movable relative to the support member, wherein the movable member is configured to hold at least one die; and an actuator configured, on actuation, to move the movable member relative to the support member so as to flip the die and move the die along a die path to place the die on an acceptor substrate, wherein the stage is arranged such that the die path extends further in a direction perpendicular to a plane of the acceptor substrate than in a direction parallel to the plane of the acceptor substrate.

According to an embodiment, there is provided a method for die placement comprising: actuating an actuator to move a movable member relative to a support member so as to flip a die held by the movable member and move the die along a die path to place the die on an acceptor substrate, wherein the die path extends further in a direction perpendicular to a plane of the acceptor substrate than in a direction parallel to the plane of the acceptor substrate.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 schematically depicts a bonding tool comprising a stage for die placement.
Figures 3-7 schematically depict the stage of Figure 1 at different points in time.
Figure 8 schematically depicts an alternative bonding tool comprising the stage for die placement.
Figures 9-14 schematically depict alternative stages for die placement.
Figure 15 schematically depicts a conveyor belt.
Figure 16 schematically depicts a cross-sectional view of the conveyor belt of Figure 15.
Figure 17 schematically depicts a die being lifted from the conveyor belt.
Figure 18 schematically depicts a die transferred from the conveyor belt to the stage for die placement.
Figure 19 schematically depicts a flexible cable or conduit.
Figure 20 schematically depicts a feedthrough for a cable or conduit.
Figure 21 schematically depicts an optional feature of the feedthrough of Figure 20.
Figure 22 is an end view of an alternative feedthrough member.
Figure 23 is a side view of the feedthrough member of Figure 22.
Figure 24 is a perspective view of the feedthrough member of Figure 22.
Figure 25 schematically depicts a balance mechanism for the stage for die placement.
Figure 26 schematically depicts an alternative feedthrough for a cable or conduit.
Figure 27 is a perspective view of the feedthrough shown in Figure 26.
Figure 28 is a cross-sectional view of the feedthrough shown in Figure 27.
Figure 29 is a schematic view of a die held by the stage shown in Figure 26.
Figure 30 is a perspective cross-sectional view of Figure 29.
Figure 31 and Figure 32 schematically depict the feedthrough shown in Figure 29 at different times of use.
Figure 33 schematically depicts the stage shown in Figure 26 holding a plurality of dies.
Figure 34 is a cross-sectional view showing an optional feature of the movable member of the stage.
Figure 35 schematically depicts in-leak into the stage shown in Figure 26.
Figure 36 schematically depicts an alternative to the stage shown in Figure 26.
Figure 37 schematically depicts an alternative to the stage shown in Figure 26.
Figure 38 is a perspective view of the stage shown in Figure 37.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

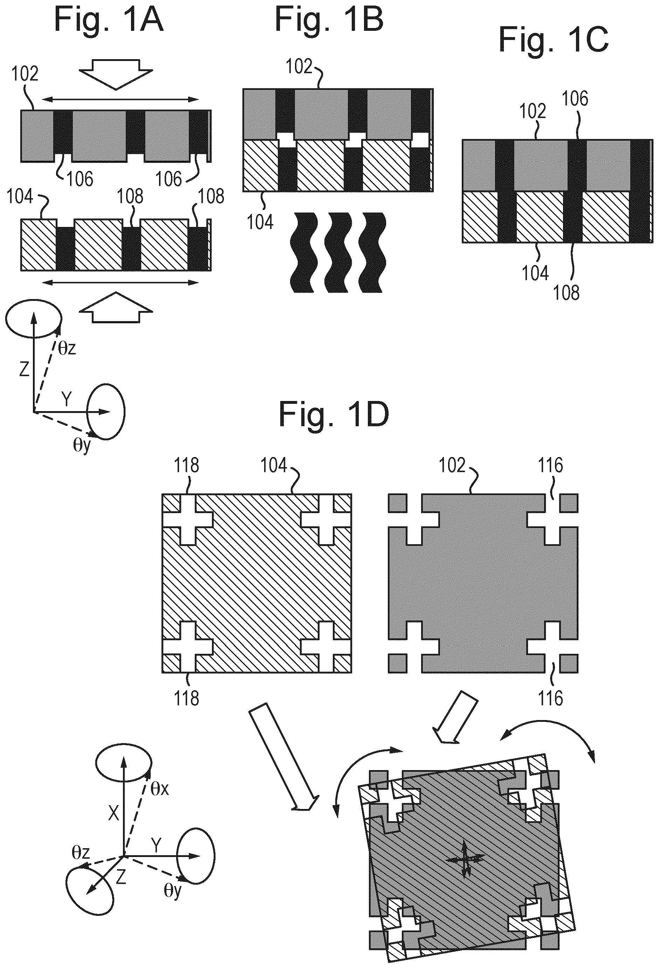

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure IB, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

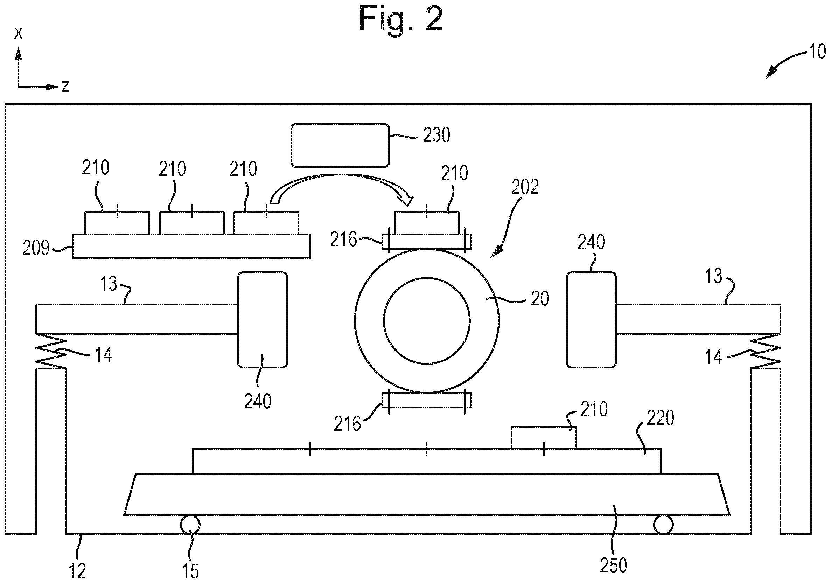

Figure 2 schematically depicts a bonding tool 10. As shown in Figure 2, the bonding tool 10 may comprise a stage 202 for die placement. The stage 202 may be configured for placing dies 210. For example, the stage 202 may be configured to place one or more dies 210 onto an acceptor substrate 220.

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 210 using support stage 202. The support stage 202 is substantially circular in the x-z plane, with a longitudinal axis along the y-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 has die acceptors 216. The placement of the die acceptors 216 may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces. The die acceptors 216 are capable of accepting donor dies, such as the donor dies 210.

The support stage 202 may be controllably moved in a direction about the longitudinal axis. The direction is provided as an example. The support stage 202 may instead be rotated in an opposite direction or any appropriate direction, translated along the x, y, or z direction or any combination thereof. The support stage 202 may be operated in both rotational and a translational modes, including sequentially or at the same time. For example, the support stage 202 may move in the negative x-direction towards a support structure 250 while also rotating about the longitudinal axis. The support stage 202 may move continuously or intermittently. For example, the support stage 202 may rotate and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 202 is substantially zero), but the positions may instead correspond to continuous (or quasi-continuous movement) or operations may occur while the support stage 202 is moving in one or more directions (e.g., rotationally, translationally, etc.).

As shown in Figure 2, in an embodiment the support structure 250 is configured to support the acceptor substrate 220 on a support surface. In Figure 2, the support surface is the upper surface of the support structure 250. In an embodiment the support surface of the support structure 250 faces the stage 202. For example, the stage 202 may be located substantially above the support surface of the support structure 250.

In an embodiment the stage 202 for die placement overlaps the support structure 250 when viewed in a direction perpendicularly to the support surface of the support structure 250. For example, in the orientation of Figure 2, the stage 202 overlaps the support structure 250 when viewed in the X-direction.

In an embodiment the stage 202 is configured to flip a die 210 and move the die 210 along a die path to place the die 210 on the acceptor substrate 220. Flipping the die 210 means that the die 210 is turned over as it is moved from the donor substrate 209 to the acceptor substrate 210. In an embodiment the die 210 is substantially planar. For example, the die 210 may be generally flat. In the orientation shown in Figure 2, the die 210 may have longer dimensions in the Y-direction and in the Z-direction compared to in the X-direction. The stage 202 is configured to flip the die 210 about an axis in the Y-Z plane. In the arrangement shown in Figure 2, one die 210 is held at the top of the stage 202, the surface of the die 210 held on the stage 202 is the surface that engages with the acceptor substrate 202. The upper surface of the die 210 when it is loaded onto the stage 202 becomes the lower surface of the die 210 when it is placed on the acceptor substrate 220.

In an embodiment the stage 202 comprises an actuator. The actuator is configured to actuate the stage 202. In an embodiment the actuator is configured, on actuation, to move the movable member 20 relative to the support member 30 so as to flip the die 210 and move the die 210 along the die path to place the die 210 on the acceptor substrate 220.

In an embodiment, the stage 202 is arranged such that the die path extends further in a direction perpendicular to a plane of the acceptor substrate 220 than in a direction parallel to the plane of the acceptor substrate 220. In the arrangement shown in Figure 2, the plane of the acceptor substrate 220 is the Y -Z plane. A direction perpendicular to the plane of the acceptor substrate 220 is the X-direction. The die path extends further in the X-direction than in the Y-Z plane. In the orientation shown in Figure 2, the X-direction is the vertical direction. The die path extends further vertically than horizontally.

The bonding tool 10 may be configured to use a stage 202 (which may be referred to as a transfer arm) that flips dies 210 around a horizontal axis. The stage 202 may be referred to as a die flipper. In an embodiment, the same stage 202 is used to place the die 210 top face down on the acceptor substrate 220. The stage 202 is configured to flip the die 210 and place the die 210 on the acceptor substrate 220.

As shown in Figure 2, in an embodiment the bonding tool 10 comprises a base frame 12. The bonding tool 10 may comprise a support structure 250 configured to support the acceptor substrate 220. The support structure 250 may be configured to move the acceptor substrate 220 at high accuracy. In an embodiment the support structure 250 that supports the acceptor substrate 220 is coupled to the base frame 12 by at least one bearing 15. In an embodiment the support structure 250 comprises a plurality of stages that may be stacked relative to each other via a plurality of bearings. For example, the support structure 250 may comprise a long stroke module for relatively coarse positioning of the acceptor substrate 220 over a longer distance, and a short stroke module for higher accuracy positioning of the acceptor substrate 220 over a shorter stroke. The short stroke module may be stacked on the long stroke module.

As shown in Figure 2, in an embodiment the bonding tool comprises a metrology frame 13. The metrology frame 13 may be referred to as an isolated frame. The metrology frame 13 may be isolated relative to the base frame 12.

As shown in Figure 2, in an embodiment the bonding tool 10 comprises an isolator 14. The isolator 14 is configured to substantially isolate the metrology frame 13 from the base frame 12. By isolating the metrology frame 13 from the base frame 12, vibrations of the base frame 12 may have less effect on the metrology frame 13.

In an embodiment, measurements of the location of a die 210 may be made relative to the metrology frame 13. As shown in Figure 2, in an embodiment the bonding tool 10 comprises two location measurement elements 240. Each location measurement element 240 is configured to measure a location of a die 210.

In an embodiment the stage 202 comprises a support member 30 and a movable member 20 that is movable relative to the support member 30. In an embodiment the movable member 20 is configured to hold at least one die 210. In an embodiment, the support member 30 is coupled to the base frame 12. Alternatively, the support member 30 may be coupled to the metrology frame 13. In an embodiment the support member 30 is secured to the base frame 12 or the metrology frame 13. Alternatively, the support member 30 may be coupled relative to the base frame 12 or the metrology frame 13 such that the support member 30 can move (e.g. along a guide) relative to the base frame 12 or metrology frame 13.

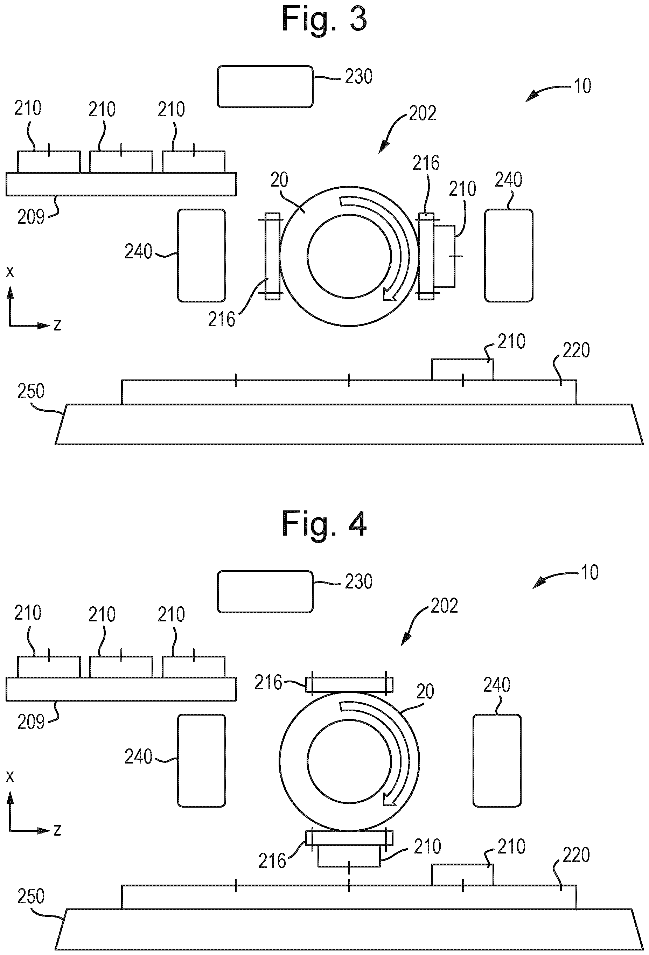

Figures 3-7 schematically depict subsequent points in time during use of the bonding tool 10 shown in Figure 2. In Figures 3-7, some components of the bonding tool 10 of Figure 2 are not shown, merely for clarity. For example, the base frame 12 and the metrology frame 13 are not shown in Figures 3-7.

As shown in Figure 3, in an exemplary use of the stage 202, the movable member 20 of the stage 202 rotates clockwise to an alignment position. The clockwise rotation is shown in Figure 3 by the curved arrow on the stage 202. Figure 3 shows a die 210 held by the stage 202 at the alignment position. At the alignment position, the position of the die 210 relative to the movable member 20 (e.g. the transfer arm) is measured. For example, the location measurement element 240 may be configured to measure the position of the die 210 relative to the movable member 20. In an embodiment, the position of the die 210 relative to the stage 202 is measured at a plurality of alignment positions so as to measure a plurality of fiducials (e.g. marks) on the die 210.

As shown in Figure 4, after alignment, the movable member 20 of the stage 202 is configured to rotate clockwise further to the place position. Figure 4 shows the die 210 held by the stage 202 at the place position. At the place position, the die 210 is flipped compared to its orientation when the die 210 was loaded onto the stage 202. In the orientation shown in Figure 4, the place position may be referred to as the bottom position. However, it is not essential for the bonding tool 10 to be oriented as shown in the Figures.

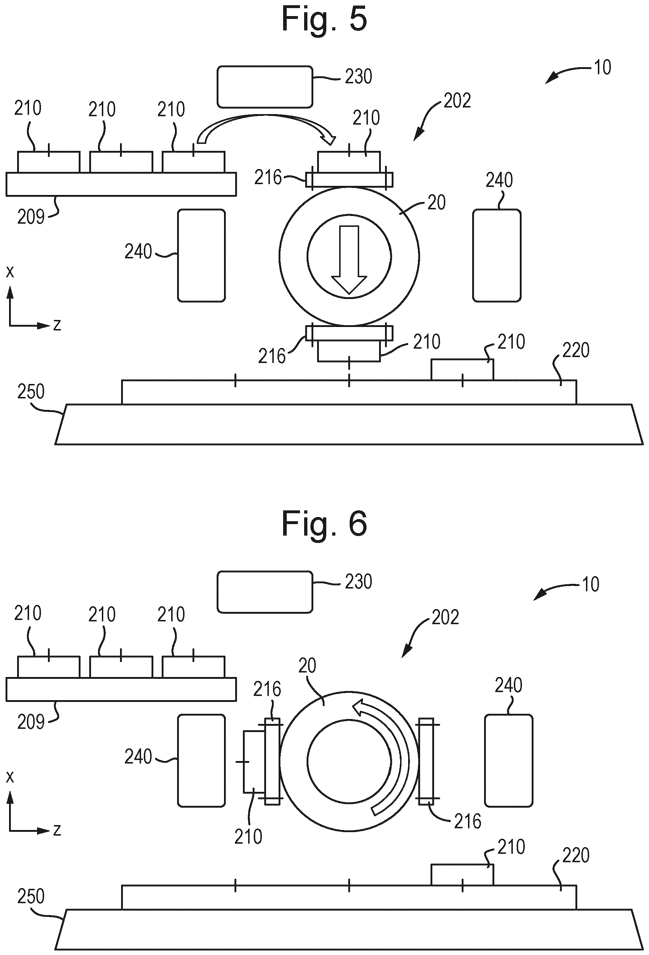

As shown in Figure 5, in the place position, the die 210 is accurately placed on the acceptor substrate 220 by a motion of the movable member 20 of the stage 202 in the X-direction (e.g. a vertical motion) of the transfer arm or part of the transfer arm in the orientation shown in Figure 5. The motion is shown in Figure 5 by the large arrow in the stage 202. As shown in Figure 5, while placing a die 210 on the place position, a new die 210 may be placed on the opposite side of the stage 202. However, it is not essential for the new die 210 to be placed onto the stage 202 at the same time that the die 210 is placed onto the acceptor substrate 220. In an alternative arrangement, the new die 210 is placed on the top side of the stage 202 only after the previous die 210 has been placed onto the acceptor substrate 220 at the opposite side of the stage 202.

As shown in Figure 5, in an embodiment the stage 202 is configured such that at least part of the movable member 20 is configured to move relative to the support member 30 in the direction perpendicular to the plane of the acceptor substrate 220 (e.g. the X-direction) so as to place the die 210 onto the acceptor substrate 220. In general, the stage 202 may be configured to perform a rotational motion to flip the die 210 and a vertical motion to place the die 210 onto the acceptor substrate 220. However, the stage 202 may be not limited to these movements. In an embodiment the stage 202 is configured such that the movable member 20 may be actuated relative to the support member 30 in six degrees of freedom. The state 202 may be configured to accurately place the die 210 onto the acceptor substrate 220.

As shown in Figure 6, after placing the die 210 onto the acceptor substrate 220, the movable member 20 may be configured to be rotated anti-clockwise towards the other location measurement element 240. The other location measurement element 240 may be configured to measure the new die 210, for example measure the location of the new die 210 relative to the movable member 20 of the stage 202. However, it is not essential for the movable member 20 of the stage 202 to be rotated in the opposite sense. In an alternative arrangement, the movable member 20 of the stage 202 may substantially continuously be rotated in the same sense (e.g. clockwise in the orientation shown in the Figures).

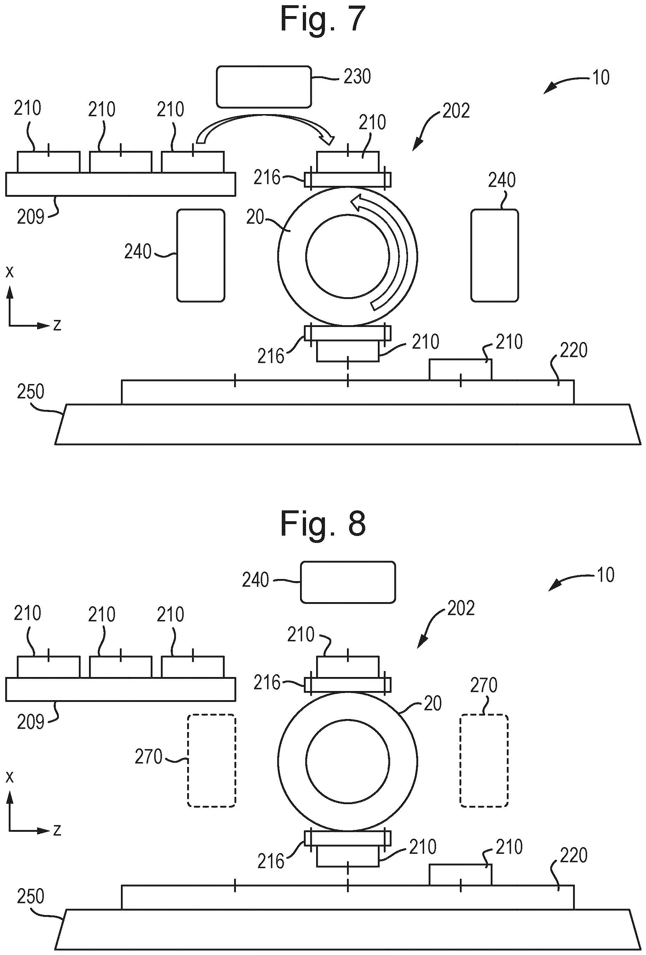

As shown in Figure 7, in an embodiment after alignment, the movable member 20 (e.g. transfer arm) is rotated further anti-clockwise. After that, the previously described steps may be repeated. In particular, the die 210 that has its location measured may be placed onto the acceptor substrate 220. A subsequent die 210 may be loaded onto the stage 202. For example, as shown in the Figures, in an embodiment the bonding tool 10 comprises a pick and place robot 230. The pick and place robot 230 may be configured to load dies 210 onto the stage 202.

Figure 8 schematically depicts an alternative bonding tool 10. As shown in Figure 8, in an embodiment the bonding tool 10 comprises only one location measurement element 240. The location measurement element 240 may be located such that the stage 202 is located between the location measurement element 240 and the acceptor substrate 220. The location measurement element 240 may be on the opposite side of the stage 202 from the acceptor substrate 220. For example, the location measurement element 240 may be located at the top side of the stage 202.

As shown in Figure 8, there may be a plurality of positions available for other processes around the stage 202. For example, as shown in Figure 8 both sides of the stage 202 may be available for other processes. As shown in Figure 8, in an embodiment the bonding tool 10 comprises one or more acceptor exchange elements 270. An acceptor exchange element 270 may be secured to the metrology frame 13. The acceptor exchange element 270 may be configured to exchange a die acceptor 216 of the stage 202 for a replacement die acceptor 216. Alternatively, the nozzle exchange elements 270 may be omitted.

As shown in Figures 2-8, in an embodiment the movable member 20 of the stage 202 is configured to rotate about an axis substantially parallel to the plane of the acceptor substrate 220 so as to flip the die 210 while moving the die 210 in the direction perpendicular to the plane of the acceptor substrate 220. In the orientation shown in Figures 2-8, the movable member 20 may be configured to rotate about the Y-axis so as to flip the die 210 while moving the die 210 in the X-direction. The die 210 may be simultaneously moved in the Z-direction.

As shown in Figures 2-7, in an embodiment the movable member 20 is configured to rotate in both directions about the axis substantially parallel to the plane of the acceptor substrate 220 (e.g. the Y-axis). In other words, the stage 202 may be configured to perform a back and forth motion during use of the stage 202 to place a series of dies 210 onto the acceptor substrate 220. By providing such a back and forth motion, it is not necessary for the stage 202 to be capable of an infinite rotational stroke. The design freedom of the stage 202 may be increased. An embodiment of the invention is expected to make it easier to manufacture the stage 202.

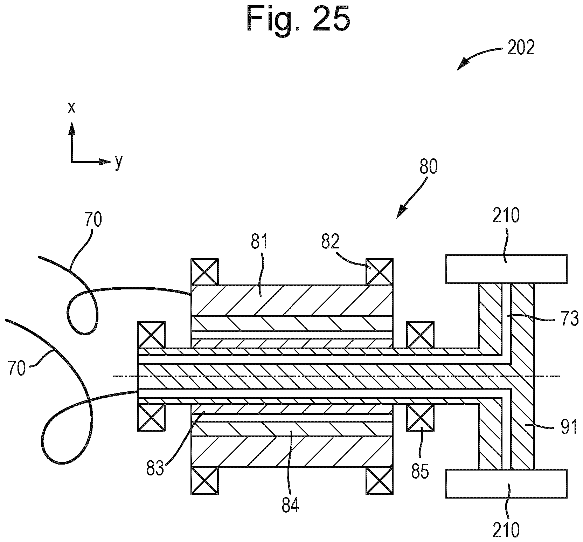

By providing that the stage 202 performs a back and forth motion, it may be easier to equip the stage 202 with a balance mechanism (which may be referred to as a balance mass mechanism). A balance mechanism may help to reduce the amount of torque exerted on the environment during acceleration and deceleration of the movable member 20 of the stage 202. A balance mechanism is explained in more detail particularly with reference to Figure 25.

As shown in Figures 2-8, in an embodiment the die path is curved. The die path may comprise an arc, for example a circular arc. As shown in Figure 3 and Figure 4, in an embodiment the stage 202 is configured to move a first die 210 along the die path. The movement may include rotating the movable member 20 in a first direction about the axis substantially parallel to the plane of the acceptor substrate 220 (e.g. the Y-axis) to place the first die 210 on the acceptor substrate 220. As shown in Figure 6 and Figure 7, in an embodiment the stage 202 is configured to move a second die 210 along a second die path. The movement may include rotating the movable member 20 in a second direction about the axis substantially parallel to the plane of the acceptor substrate 220 (e.g. the Y-axis) to place the second die 210 on the acceptor substrate 220. The second direction may be opposite to the first direction. In Figures 2-7, the first direction is substantially clockwise. The second direction is substantially anti-clockwise. The stage 202 may be configured to move in opposite senses to place sequential dies 210. Alternating dies 210 may follow alternating die paths.

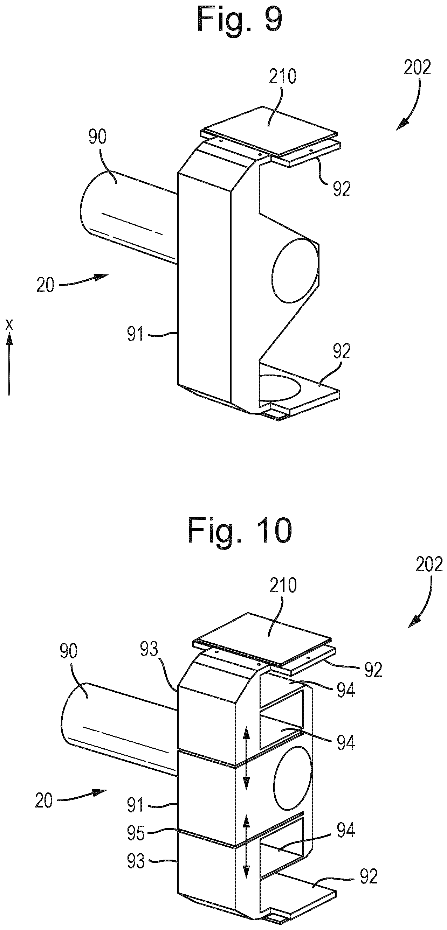

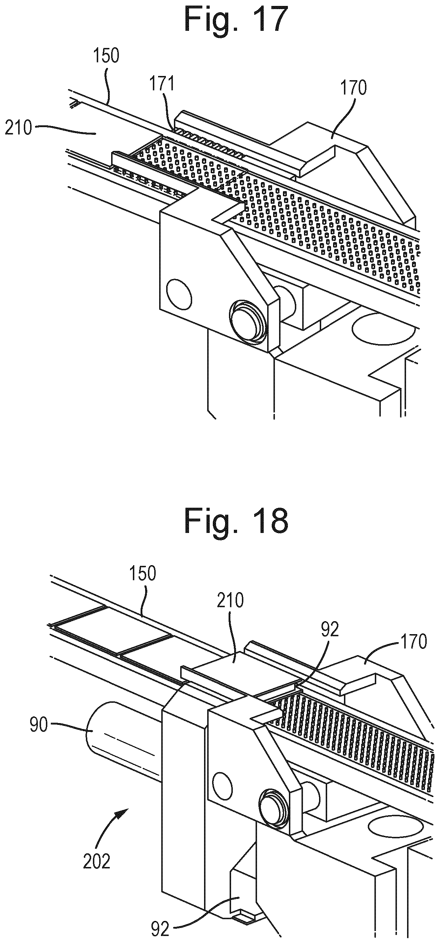

Figure 9 schematically depicts an alternative stage 202. The stage 202 may be part of the bonding tool 10 shown in Figure 2, for example. In the arrangements shown in Figures 2-8, the stage 202 comprises a movable member 20 that is shaped like a wheel or a turret. Figure 9 shows a stage 202 comprising a transfer arm 91 as the movable member 20. As shown in Figure 9, the movable member 20 may be generally C-shaped. The stage 202 shown in Figure 9 comprises two die acceptors 216 formed as protruding arms 92 (or protruding platforms). The protruding arms 92 protrude from the transfer arm 91. As shown in Figure 9, in general there may be a space below the upper protruding arm 92. Similarly, there may be a space above the lower protruding platform 92. The die acceptors formed by the protruding arms 92 may protrude between the die 210 helped by the protruding platform 92 and a gap. The gap provides a space for accommodating an external component. This is shown in more detail with reference to Figure 18.

As shown in Figure 9, in an embodiment a pair of die acceptors 216 (e.g. formed by protruding arms 92) are provided on opposing protruding arms of the movable member of the stage 202. A die 210 may be loaded onto one of the die acceptors. The die 210 may be placed onto the acceptor substrate 220 from the opposing die acceptor 216.

As shown in Figure 9, in an embodiment the movable member 20 of the stage 202 comprises a shaft 90. The shaft 90 is configured to support the protruding arms 92 and to rotate relative to the support member 30. The shaft 90 is configured to rotate about the axis of the shaft 90.

Figure 9 shows a die 210 loaded on the upper protruding arm 92. For placing the die 210 onto the acceptor substrate 220, the transfer arm 91 together with the shaft 90 and the protruding arms 92 may be configured to move in the X-direction. In an embodiment, a controller is provided for controlling actuation of the stage 202. In an embodiment the controller is configured to reduce the speed of the transfer arm 91 in the X-direction immediately before the die 210 at the bottom of the stage 202 makes contact with the acceptor substrate 220. By reducing the collision speed, the impact force of the die 210 bumping into the acceptor substrate 220 may be reduced.

Figure 10 schematically depicts an alternative arrangement of a stage 202 for die placement. Features that are the same as in the arrangement shown in Figure 9 are not repeated for conciseness. In the arrangement shown in Figure 9, the shaft 90 is movable relative to the support member 30 in a direction radial to an axis of the shaft 90. For example, the shaft 90 may have an axis corresponding to the Y-axis of Figure 2. The shaft 90 may be movable relative to the support member 30 in the X-direction, i.e. the vertical direction.

However, it is not essential for the shaft 90 to be movable in the X-direction. In the arrangement shown in Figure 10, the shaft 90 may remain substantially stationary in the X-direction. As shown in Figure 10, in an embodiment the protruding arms 92 are configured to move relative to the shaft 90 in a direction radial to an axis of the shaft 90. For example, the stage 202 may be configured such that the protruding arms 92 are configured to move relative to the shaft 90 in the X-direction.

In the arrangement shown in Figure 10, it is not necessary for the complete arm (i.e. the shaft 90 together with the transfer arm 91 and the protruding arms 92) to move in the vertical direction. In an embodiment the stage 202 comprises one or more actuators configured to actuate the protruding arms 92 in the X-direction. In an embodiment, two actuators are provided so as to move the dies 210 on opposite sides of the stage 202 separately. The protruding arms 92 may be independently controllable of each other. In an embodiment, each actuator is configured, on actuation, to move the protruding arm 92 relative to the transfer arm 91 and the shaft 90. The transfer arm 91 may be secured to the shaft 90.

As shown in Figure 10, in an embodiment each protruding arm 92 is configured to move relative to the transfer arm 91 and the shaft 90 in a guided motion. For example, the stage 202 may comprise a parallel leaf spring guide for each protruding arm 92. The parallel leaf spring guide may comprise a pair of leaf springs 94. As shown in Figure 10, each protruding arm 92 may be secured to a guide arm 93. The guide arms 93 may be separated from the transfer arm 91 by a gap 95. The leaf springs 94 are configured to allow movement of the protruding arm 92 relative to the transfer arm 91 and the shaft 90 in the X-direction.

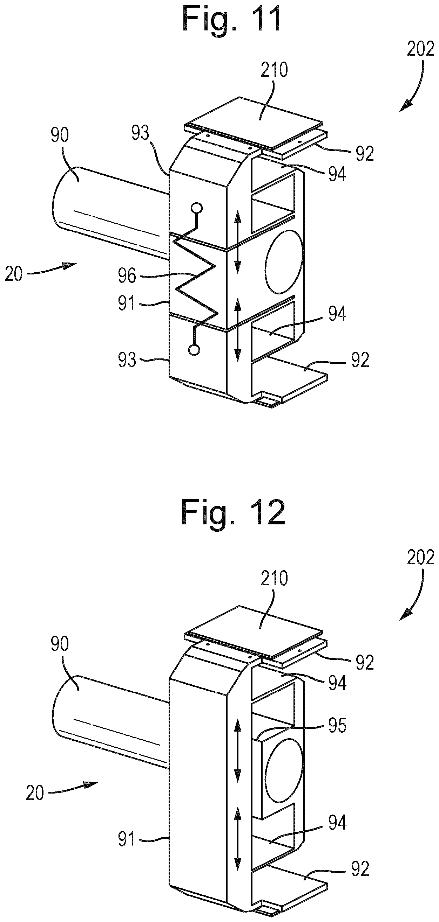

Figure 11 schematically depicts an alternative stage 202. Features that are the same as described in Figure 9 or Figure 10 are not repeated, for conciseness.

As shown in Figure 11, in an embodiment the movable member 20 of the stage 202 comprises a spring 96. The spring 96 is configured to at least partly compensate for a centrifugal force associated with the protruding arms 92 during rotation of the shaft 90. In particular, during fast rotation the centrifugal force can be high. Due to the centrifugal force, it may be necessary for the actuators that control movement of the protruding arms 92 in the radial direction to generate a high force. This may increase power consumption and/or undesirably produce heat.

In the arrangement shown in Figure 11, the spring 96 is configured to preload the protruding arms 92. As a result, the spring 96 may counteract the centrifugal force during rotation. During placement (i.e. when rotation is zero or low), the actuator that moves the protruding arm 92 holding the die 210 to be placed (at the bottom of the stage 202) generates a force to place the die 210 on the acceptor substrate 220. During rotation, the actuators may not be needed to generate a significant force because the spring 96 generates the necessary force.

In the arrangement shown in Figure 10 and Figure 11, the protruding arms 92 are movable relative to each other. Figure 12 schematically depicts an alternative stage 202 in which the protruding arms 92 are fixed relative to each other. Similarly, Figure 9 schematically depicts a stage 202 in which the protruding arms 92 are fixed relative to each other. In the arrangement shown in Figure 12, the protruding arms 92 are configured to move together relative to the shaft 90. The protruding arms 92 are configured to move together in the X-direction. In Figure 12, the stage 202 is configured such that the protruding arms 92 are movable relative to the shaft 90. In contrast, Figure 9 shows an arrangement in which the protruding arms 92 are fixed relative to the shaft 90.

In the arrangement of Figure 10 and the arrangement of Figure 11, two separate translations in the X-direction are controllable, one for each protruding arm 92. In the embodiment shown in Figure 12, the two separate X-direction translations are combined into one X-direction translation. This can help to counteract the centrifugal forces. In particular, the centrifugal force during rotation of the shaft 90 cannot cause the protruding arms 92 to move apart from each other because they are fixed relative to each other.

Instead of providing two separate actuators for actuating each protruding arm 92 (as in the arrangements of Figure 10 and Figure 11), the stage 202 may be provided with a single placement actuator configured, on actuation, to move the protruding arms 92. Only one actuator is needed to be used. In an embodiment the actuator is configured to actuate the protruding arms 92 during placement of a die 210 onto the acceptor substrate 220.

In an alternative embodiment, the stage 202 may comprise a plurality of placement actuators. For example, the arrangements shown in Figure 10 and Figure 11 comprise two placement actuators for performing the X-direction translations for placing the dies 210 onto the acceptor substrate 220.

In the arrangement shown in Figure 12, only a single placement actuator is required. By providing only one placement actuator, the mass of the stage 202 may be reduced. In the arrangement shown in Figure 12, the placement actuator is not required to overcome the centrifugal force. The placement actuator can be smaller, leading to less mass of the stage 202. By reducing the mass of the stage 202, the torque applied by the stage 202 on the base frame 12 or the metrology frame 13 may be reduced.

In an embodiment, the placement actuator (or at least one of the placement actuators) is a Lorentz force actuator. The Lorentz force actuator may comprise coils in the support member 30 and magnets fixed relative to the protruding arms 92.

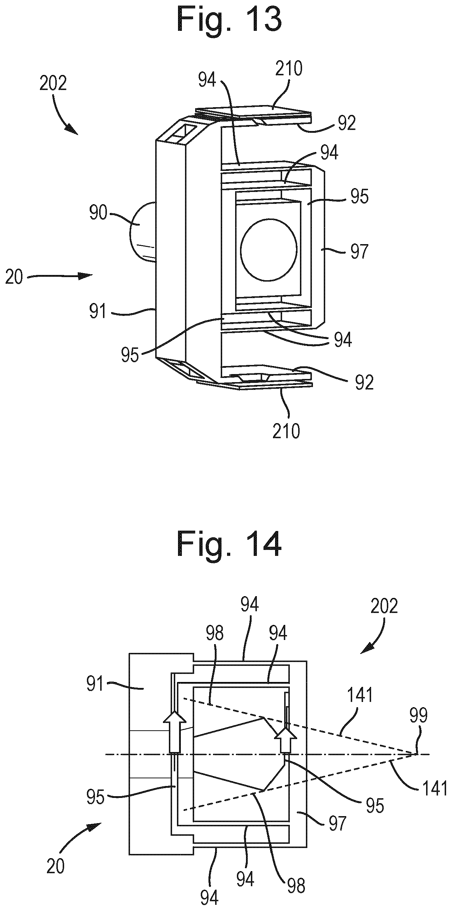

Figure 13 schematically depicts an alternative stage 202. Features that are the same as described in relation to any of Figures 9-12 are not described, for conciseness.

As shown in Figure 13, in an embodiment the movable member 20 of the stage 202 comprises a double parallel leaf spring guide connecting the shaft 90 to the protruding arms 92 via an intermediate body 97. The double parallel leaf spring guide may be configured to reduce or substantially prevent parasitic motions. Such parasitic motions may be in the sideways direction.

As shown in Figure 13, in an embodiment the transfer arm 91 is separated from the shaft 90 by a gap 95. The shaft 90 may be separated from the intermediate body 97 by another gap 95. The shaft 90 may be located between the transfer arm 91 and the intermediate body 97. The protruding arms 92 may be fixed relative to the transfer arm 91. The protruding arms 92 may be fixed relative to each other.

Figure 14 schematically depicts an alternative stage 202. Features that are the same as described with reference to any of Figures 9-12 are not described, for conciseness.

As shown in Figure 14, in an embodiment the stage 202 comprises lever flexures 98. As shown in Figure 14, the lever flexures may be angled relative to each other so as to form a virtual hinge 99. The virtual hinge 99 functions as a hinge between the intermediate body 97 and the protruding arms 92 (which are fixed to the transfer arm 91 shown in Figure 14). Figure 14 shows imaginary lines 141 corresponding to continuations of the planes of the lever flexures 98 in the X-Z plane. The lever flexures 98 may be leaf springs. The large arrows in Figure 14 show the relative movements of the transfer arm 91 (i.e. the protruding arms 92) and the intermediate body 97. In an embodiment, the leaf springs 94 all have substantially the same stiffness. The motion of the intermediate body 97 may be substantially half of the transfer arm 91. By providing the virtual hinge 99, the Eigen frequency of the intermediate body 97 may be increased significantly.

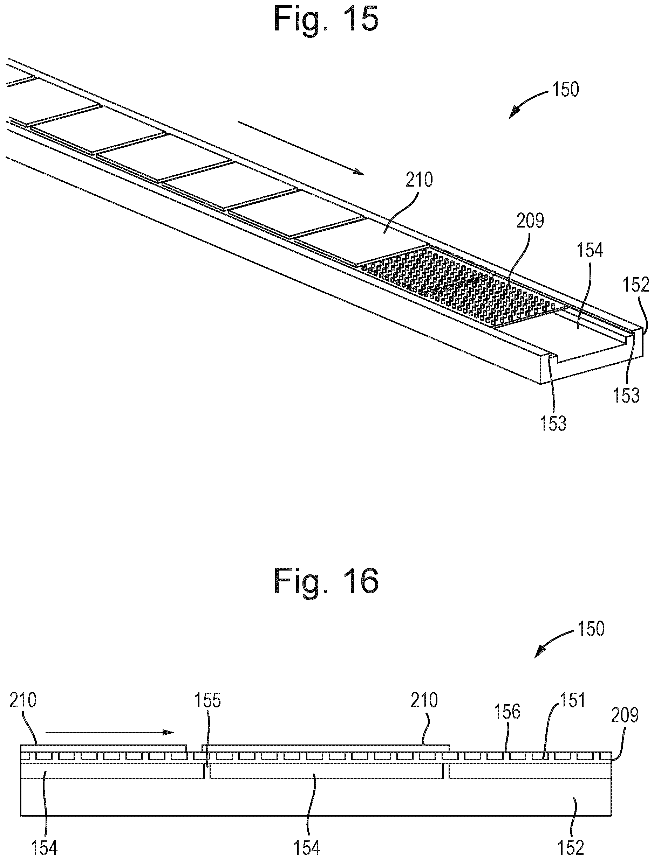

In an embodiment the bonding tool 10 comprises a conveyor belt 150. Figure 15 schematically depicts a conveyor belt 150 that may be comprised in the bonding tool 10. In an embodiment the conveyor belt 150 is configured to convey dies 210. The conveyor belt 150 may comprise the donor substrate 209.

In an embodiment the conveyor belt 150 is configured to convey dies 210 in a direction substantially parallel to the plane of the acceptor substrate 220. For example, in the orientation shown in Figure 2, the conveyor belt 150 may be configured to convey dies 210 in the Z-direction. In an embodiment the conveyor belt 150 is configured to convey dies 150 towards the acceptor substrate 220. For example, the dies 210 may be loaded onto the conveyor belt 150 at a remote location, i.e. a location relatively far from the support structure 250. The dies 210 may be conveyed to the acceptor substrate 220. This may allow more space in a volume further from the acceptor substrate 220 for a substrate that holds the dies 210 before they are placed onto the conveyor belt 150. In an embodiment the conveyor belt 150 is configured to horizontally transfer the dies 210.

In an embodiment the dies 210 may be clamped onto the conveyor belt 150. For example, as shown in Figure 15 the conveyor belt 150 may comprise the donor substrate 209 shown in Figure 2. The donor substrate 209 may be formed of a belt of the conveyor belt 150. In an embodiment the belt comprises burls with holes.

Figure 16 is a cross-sectional view of the conveyor belt 150. As shown in Figure 16, in an embodiment the conveyor belt 150 comprises burls 156. The burls 156 have distal ends arranged in a plane for supporting the dies 210. The belt may comprise a base substrate 151. The burls 156 may protrude from the base substrate 151.

In an embodiment the conveyor belt 150 comprises a plurality of vacuum pockets 154. In an embodiment a vacuum pocket 154 is provided for a respective die 210. The base substrate 151 of the belt may be provided with a plurality of apertures or holes to apply the vacuum force to the dies 210. An under pressure may be applied to the vacuum pocket 154 for clamping a die 210 to the belt.

By providing that the belt has burls 156, there is space below the die 210 for applying a clamping vacuum and/or for allowing a device to lift the die 210 from the conveyor belt 150.

In an embodiment the burls 156 are provided with apertures within them. In an alternative embodiment, the base substrate 151 is provided with apertures for applying a vacuum. In a further alternative embodiment holes are provided in both the base substrate 151 and the burls 156.

As shown in Figure 15, in an embodiment the conveyor belt 150 comprises guiding grooves 153. The guiding grooves 153 are configured to guide movement of the belt that forms the donor substrate 209 along the conveyor belt 150.

As shown in Figure 16, in an embodiment the conveyor belt 150 comprises separators 155 for separating adjacent vacuum pockets 154. The separators 155 are configured to separate compartments from each other such that the pressure in one compartment can differ from a compartment next to it. The separators 155 may be, for example, walls. In an embodiment, inside each vacuum pocket 154 a separate volume is made. Locally the vacuum pressure can be controlled. For example, that the die pickup position, the vacuum pressure locally can be removed, such that there is substantially no vacuum force any more between the burls 156 and the die 210. This allows the die 210 to be picked up relatively easily without any remaining vacuum force.

As shown in Figure 15 and Figure 16, in an embodiment the conveyor belt 150 comprises a housing 152. The housing 152 is configured to at least partly define the vacuum pockets 154. The housing 152 may comprise the separators 155 separating the vacuum pockets 154. In an embodiment the housing 152 defines the guiding grooves 153 for guiding the belt along the housing 152.

In an embodiment the guiding grooves 153 are configured to use a gas bearing to guide the belt that forms the donor substrate 209.

Figure 17 schematically depicts a die 210 being removed from the conveyor belt 150. As shown in Figure 17, in an embodiment a die remover 170 is configured to remove a die 210 from the conveyor belt 150. As shown in Figure 17, in an embodiment the die remover 170 comprises a plurality of fingers 171. The fingers 171 may be configured to extend between the burls 156 below the die 210. In an embodiment, the fingers 171 contain holes to supply an under pressure, e.g. a vacuum. Once the fingers 171 are below the die 210, the fingers 171 may be lifted so as to lift the die 210 from the conveyor belt 150.

Figure 18 schematically depicts a die 210 being loaded on to the stage 202. As shown in Figure 18, when the die 210 is lifted from the conveyor belt 150, the stage 202 can rotate underneath the die 210. The protruding arm 92 can take the die 210 over from the die remover 170. For example, the fingers 171 of the die remover 170 may be lowered. Additionally or alternatively, the protruding arm 92 of the stage 202 may be lifted to separate the die 210 from the fingers 171 of the die remover 170. By providing that the protruding arms 92 are protruding, the protruding arms 92 can fit under the die 210 that has been lifted from the conveyor belt 150. The protruding arm 92 can protrude between the die 210 and the conveyor belt 150. The conveyor belt 150 can occupy the space below the upper protruding arm 92.

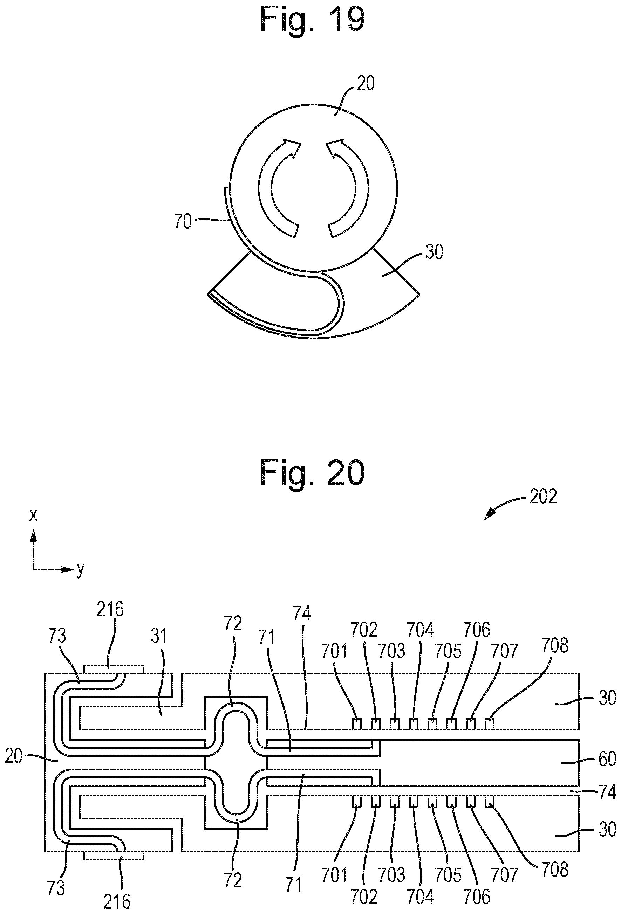

Figure 19 schematically depicts a flexible element 70. The flexible element 70 may be connected between the stage 202 and the frame to which the stage 202 is coupled. For example, Figure 19 shows the flexible element 70 connected between the base frame 12 and the stage 202. The flexible element 70 may be, for example, an electrical transmission line or a fluid conduit. For example, the flexible element 70 may be a wire, or a hose. In an embodiment the flexible element 70 is configured to extend between the support member 30 and the movable member 20 of the stage. The flexible element 70 may be configured to flex during movement of the movable member 20 relative to the support member 30.

By providing that the motion of the movable member 20 may be a back and forth motion, the stroke of the movable member 20 may be limited. Accordingly, cables (e.g. for motor power, electrostatic clamps or other purposes) and hoses (e.g. for vacuum clamping, water cooling or other purposes) can be supplied relatively easily to the movable member 20. For example, a rotary cable or a hose slab may be provided. Figure 19 shows the flexible element 70 that may be provided as a rotary table.

Figure 20 schematically depicts an alternative arrangement. As shown in Figure 20, in an embodiment the stage 202 comprises a feedthrough member 60. The feedthrough member 60 is configured to rotate together with the movable member 20 relative to the support member 30. As shown in Figure 20, in an embodiment the feedthrough member 60 comprises at least one fluid conduit 71. The fluid conduit 71 may be configured to apply a vacuum pressure for clamping a die 210 to a die acceptor 216 of the movable member 20, for example. Additionally or alternatively, a fluid conduit 71 may be configured to apply a thermal conditioning fluid, for example for cooling a component. Although a fluid conduit 71 is shown in Figure 20, additionally or alternatively, the feedthrough member 60 comprises an electrical transmission line. Such an electrical transmission line may be configured to supply control signals, power or an electrostatic clamping force to the movable member 20.

In the arrangement shown in Figure 20, the movable member 20 is configured to rotate relative to the support member 30. During rotation, the feedthrough member 60 may rotate together with the movable member 20. As shown in Figure 20, the feedthrough member 60 may be configured with a gas bearing 74 relative to the support member 30.

The feedthrough member 60 is not fixed relative to the movable member 20. As shown in Figure 20, the feedthrough member 60 may be coupled to the movable member 20 by dynamic links 72. In an embodiment the stage 202 comprises at least one electrical transmission line and/or at least one fluid conduit extending between the feedthrough member 60 and the movable member 20. The at least one electrical transmission line and/or fluid conduit that extends between the feedthrough member 60 and the movable member 20 may be configured to flex during movement of the movable member 20 relative to the support member 30. Although the feedthrough member 60 may rotate substantially synchronously with the movable member 20, there may be some movement of the movable member 20 relative to the feedthrough member 60. In an embodiment the accuracy of control of movement of the movable member 20 may be greater than the accuracy of control of the feedthrough member 60. By providing the dynamic links 72 as the transmission line or fluid conduits extending between the feedthrough member 60 and the movable member 20, the dynamic links can flex during movement so as to reduce any potential undesirable effect on control of movement of the movable member 20 due to the movement of the feedthrough member 60.

As shown in Figure 20, in an embodiment the feedthrough member 60 is configured such that at least one electrical transmission line and/or at least one fluid conduit remains connected between the feedthrough member 60 and the support member 30 during rotation of the feedthrough member 60 relative to the support member 30. As shown in Figure 20, the support member 30 may have defined therein gas feedthrough grooves 701-708. In Figure 20, eight gas feedthrough grooves 701-708 are shown corresponding to eight die acceptors 216 on the movable member 20. Each gas feedthrough groove 701-708 may be configured to provide a vacuum clamping force for a respective die acceptor 216. Each gas feedthrough groove 701-708 may extend circumferentially around the feedthrough member 60. Each fluid conduit 71 of the feedthrough member 60 may be open to a respective groove at a single opening. As the feedthrough member 60 rotates relative to the support member 30, the fluid conduit 71 remains in fluid communication with a groove. For example, the upper fluid conduit 71 shown in Figure 20 remains in fluid communication with the second gas feedthrough groove 702. The lower fluid conduit 71 remains in fluid communication with the third gas feedthrough groove 703.

As shown in Figure 20, in an embodiment the movable member 20 comprises a plurality of vacuum channels 73 for fluid communication between the die acceptor 216 and the gas feedthrough grooves 701-708. Additionally or alternatively, at least one electrical transmission line may be provided in the movable member 20 for providing electrical connection with the support member 30.

By providing that the feedthrough member 60 is configured such that the fluid conduit 71 remains connected during rotation of the feedthrough member 60, the stroke of the movable member 20 relative to the support member 30 may not be limited. In particular, the movable member 20 may have a substantially infinite stroke relative to the support member 30 while remaining connected for electricity and/or fluid.

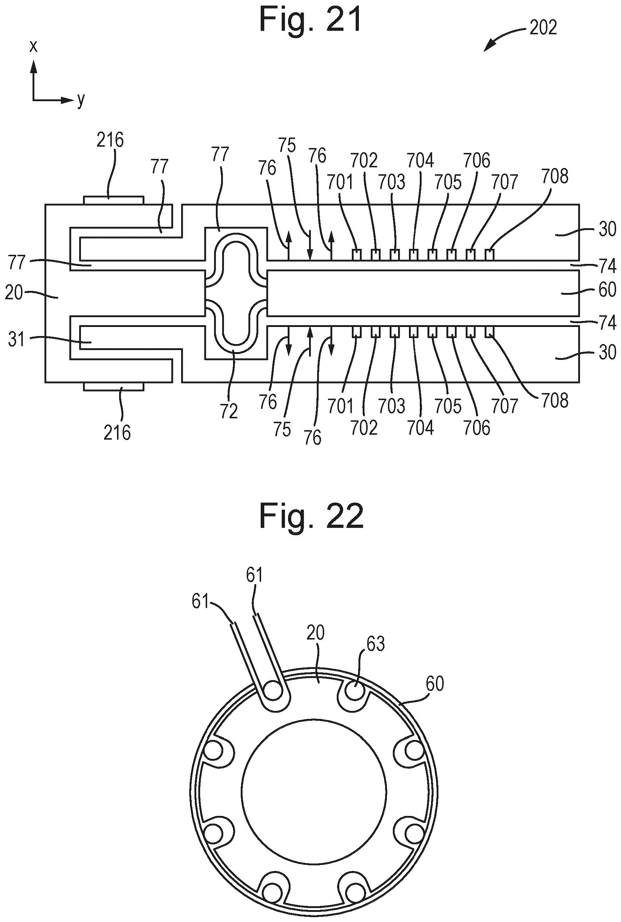

Figure 20 schematically depicts an optional feature of the stage 202 shown in Figure 20. As shown in Figure 21, in an embodiment the support member 30 comprises at least one gas supply 75. The gas supply 75 is configured to supply gas for the air bearing 74 between the support member 30 and the feedthrough member 60.

As shown in Figure 21, in an embodiment the support member 30 comprises at least one gas extractor 76. The gas extractor 76 is configured to extract gas. As shown in Figure 21, in an embodiment the support member 30 comprises a plurality of gas extractors 76. For example, gas extractors 76 may be provided at opposite ends of the series of gas feedthrough grooves 701-708.

As shown in Figure 20, in an embodiment the support member 30 comprises an additional gas extractor 76 configured to extract gas from a location between the gas supply 75 of the gas bearing 74 and the movable member 20. By providing the additional gas extractor 76, the possibility of gas particles undesirably passing through the channels 77 to reach the immediately surrounding environment of the stage 202 may be reduced. Particles may be undesirably generated during use of the bonding tool 10. By providing the additional gas extractor 76, the possibility of undesirable contamination by such particles may be reduced.

In Figure 20 and Figure 21, the feedthrough for the infinite rotational stroke is shown primarily in the context of fluid conduits. Additionally or alternatively, the feedthrough may be provided for electrical transmission lines. For example, the gas feedthrough grooves 701-708 may be replaced with stator rings. The openings of the fluid conduits 71 shown in Figure 20 may be replaced with rotor rings. A capacity of rotary joins may be provided between the feedthrough member 60 and the support member 30. In an embodiment, such a capacity of rotary joint is provided in addition to the fluid conduit and gas feedthrough grooves shown in Figure 20 and Figure 21.

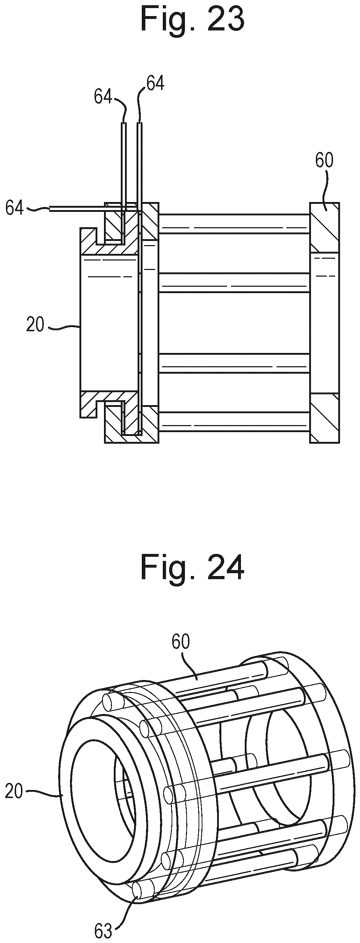

Figure 22 is a schematic view of an alternative feedthrough member 60. Figure 23 is a side on view of the feedthrough member 60. Figure 24 is a perspective view of the feedthrough member 60 relative to the movable member 20.

As shown in Figure 22, in an embodiment contact elements 63 comprise axial rods. The axial rods may extend substantially parallel to the primary axis of the Lorentz force actuator 10, for example the Y axis. The ends of the axial rods, i.e. the contact elements 63 may be configured to contact the movable member 20 during acceleration or deceleration phases. Figure 22 shows the point in time at which the contact elements 63 are distanced from the movable member 20 by gaps 61.

During acceleration or deceleration phases, the feedthrough member 60 may be controlled to move relative to the movable member 20 so that one of the gaps 61 is reduced to zero. In an embodiment, the axial rods that form the contact elements 63 may be compliant, so as to reduce impact forces on the movable member 20. This may help to increase the accuracy with which the movements of the movable member 20 can be controlled.

As shown in Figure 23, in an embodiment the feedthrough member 60 may be arranged relative to the movable member 20 such that there are further gaps 64 in the Y direction and in the X or Z directions. These further gaps 64 may be for allowing movement of the movable member 20 relative to the support member 30 in the five degrees of freedom (in addition to the rotation about the Y axis).

As shown in Figures 22-24, in an embodiment the feed through member 60 comprises a stroke limiter. The stroke limiter is configured to limit a stroke of the movable member 20 relative to the feed through member 60. The stroke limiter may be configured to prevent the movable member 20 from separating completely away from the support member 30 such that the position of the movable member 20 can no longer be controlled.

The stroke limiter is configured to reduce possible damage to the stage 202. In particular, the stroke limiter may help to reduce damage to dynamic link hoses (e.g. for a thermal conditioner) and/or cables (e.g. for applying electric potentials to the coils 31 or the die acceptors 216). In an embodiment the stroke limiter is configured to limit the strokes in all six degrees of freedom.

Figure 25 schematically depicts an optional feature of the stage 202 of any embodiment. As shown in Figure 25, in an embodiment the stage 202 comprises a balance mechanism 80. In an embodiment the stage comprises a balance mass 81. The balance mass 81 is configured to move relative to the support member 30 so as to reduce torque exerted by the stage 202 during use of the stage 202. In an embodiment, the rotating balance mass 81 is configured to reduce or minimise the amount of torque exerted by the stage 202 on its environment during acceleration and deceleration.

As shown in Figure 25, in an embodiment the transfer arm 91 of movable member 30 of the stage 202 is coupled to the frame (e.g. the base frame 12) by transfer arm bearings 85. In an embodiment, the balance mass 81 is coupled to a frame (e.g. the base frame 12) by balance mass bearings 82. In an embodiment, the balance mass bearings 82 are ball bearings. Alternatively, the balance mass bearings 82 may be gas bearings, or magnetic levitated bearings, for example.

As shown in Figure 25, in an embodiment the balance mechanism 80 comprises a Lorentz force actuator. The Lorentz force actuator may comprise motor coils 84 and motor magnets 83. In an alternative embodiment, the balance mechanism 80 comprises an alternative type of actuator configured, on actuation, to move the balance mass 81. The balance mechanism 80 is configured such that the balance mass 81 rotates so as to compensate for the torque exerted by the stage 202.

In an embodiment, the balance mass 81 is configured to move relative to the support member 30 in a direction opposite to a direction in which the movable member 20 is moving relative to the support member 30. By moving in the opposite direction, the torque exerted by the stage 202 may be reduced. The torque may be exerted on the base frame 12, for example.

In an embodiment the stage 202 comprises an anti-drift mechanism configured to reduce drifting of a speed of movement of the balance mass 81 relative to the support member 30. The anti-drift mechanism is configured to reduce or avoid drifting of the balance mass 81. During use of the balance mass 81, the balance mass 81 may be rotated by the actuator (e.g. the Lorentz force actuator). Subsequently the actuator may apply a force to substantially stop the rotation of the balance mass 81. However, it is possible that the balance mass 81 may have a residual rotation. During prolonged use of the stage 202 and the balance mass 81, the residual motion of the balance mass 81 may cumulatively increase. The anti-drift mechanism is configured to reduce such drifting of the speed of movement of the balance mass 81.

In an embodiment the anti-drift mechanism comprises a torsional spring. Additionally or alternatively, the anti-drift mechanism may comprise a rotary motor configured to apply a force to the balance mass 81.

As shown in Figure 20 and Figure 21, for example, in an embodiment the stage 202 comprises multiple feedthrough channels. The feedthrough channels enable the clamping levels to be controlled at the rotating movable member 20. In Figure 20 and Figure 21, the feed through channels are for pneumatics. That is, the feed through channels are formed by fluid conduits 71, dynamic links 72 and vacuum channels 73. In an alternative arrangement, the feedthrough channels may be for electrical charge. The feedthrough channels may be formed by electrical transmission lines. The clamping of the dies may be by vacuum pressure or by electrostatic clamping. In a further alternative, both vacuum clamping and electrostatic clamping are used. As shown in Figure 20 and Figure 21, in an embodiment the multiple feedthrough channels are arranged in parallel.

In an embodiment each feedthrough channel can be switched on or off independently at any time. This is because the feedthrough channels are placed in parallel. However, it is not essential for the feedthrough channels to be arranged in parallel.

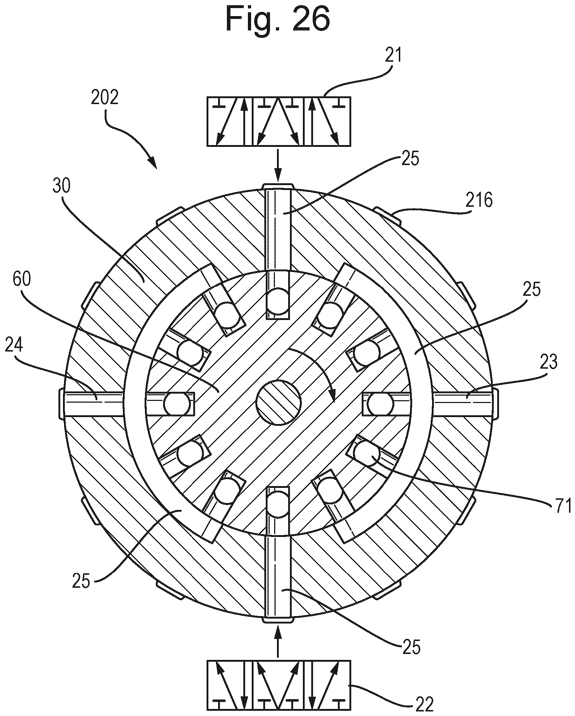

Figure 26 schematically depicts a stage 202 comprising an alternative support member 30 and an alternative feedthrough member 60. Figure 26 schematically depicts the supply section of the feedthrough. Figure 26 is a view along the axis of rotation of the feedthrough member 60 (and the movable member 20).

As shown in Figure 26, in an embodiment the feedthrough member 60 comprises a plurality of electrical transmission lines and/or a plurality of fluid conduits 71 for controlling clamping of respective dies 210. In the arrangement shown in Figure 26, twelve fluid conduits 71 are shown for clamping twelve respective dies 210 at respective die acceptors 216.

The feedthrough member 60 is configured to rotate relative to the support member 30 in the direction of the arrow shown in Figure 26. In the orientation shown in Figure 26, one of the twelve fluid channels 71 is located at the upper side of the stage 202. This fluid channel 71 is for clamping a die 210 at the top of the stage 202. Another of the fluid channels 71 is at the lower side of the feedthrough member 60. This fluid channel 71 is for clamping the die 210 at the lower side of the stage 202. There are ten other fluid channels 71 shown, in two groups of five.

As shown in Figure 26, in an embodiment the stage 202 comprises an upper clamp controller 21. The upper clamp controller is configured to control clamping of a die 210 held at the upper side of the movable member 20. The upper clamp controller 21 is configured to control the clamping via the corresponding electrical transmission line and/or fluid conduit 71. In an embodiment the upper clamp controller 21 comprises a valve. The valve is configured to control clamping of the upper die 210 on the movable member 20. It is not essential for the upper clamp controller 21 to comprise a valve. For example, when the clamping is electrostatic, the upper clamp controller may be configured to control the electric potential applied to an electrode via the electrical transmission line. In an embodiment the upper clamp controller is configured to control the clamping level substantially continuously over a range of clamping levels. Alternatively, the upper clamp controller 21 may be configured to switch between a plurality of different clamping levels. For example, the upper clamp controller 21 may be configured to switch between a clamping level (e.g. vacuum) to clamp a die 210, a release level (e.g. an over pressure) for quick release of a die 210 and/or one or more intermediate levels (e.g. an ambient pressure).

As shown in Figure 26, in an embodiment the stage 202 comprises a lower clamp controller 22. The lower clamp controller 22 is configured to control clamping of a die 210 held at a lower side of the movable member 20. The lower clamp controller 22 is configured to control the clamping via the corresponding electrical transmission line and/or fluid conduit 71. When the clamping is pneumatic, the lower clamp controller 22 may comprise a valve configured to switch the lower die clamp on the movable member 20.

In an embodiment the lower clamp controller 22 is configured to control the clamping level similarly to the upper clamp controller 21. For example, the lower clamp controller 22 may be configured to switch between different pressure levels such as vacuum (to clamp a die 210), over pressure (for quick release of a die 210) and if needed ambient or other pressure levels.

As shown in Figure 26, in an embodiment the upper clamp controller 21 and the lower clamp controller 22 are connected to the fluid conduits 71 (or electrical transmission lines) via connecting conduits 25. Figure 26 shows one connecting conduit 25 at the upper side of the support member 30 and another connecting conduit 25 at the lower side of the support member 30. As the feed through member 60 rotates relative to the support member 30, the identity of the fluid channel 71 (or electrical transmission line) that is in communication with the upper clamp controller 21 and the lower clamp controller 22 changes.

In an embodiment the upper clamp controller 21 is configured to be in communication with a die 210 held by the movable member 20 only when the die 210 is at the upper side of the movable member 20. In an embodiment the lower clamp controller 22 is configured to be in communication with a die 210 held by the movable member 20 only when the die 210 is at the lower side of the movable member 20.

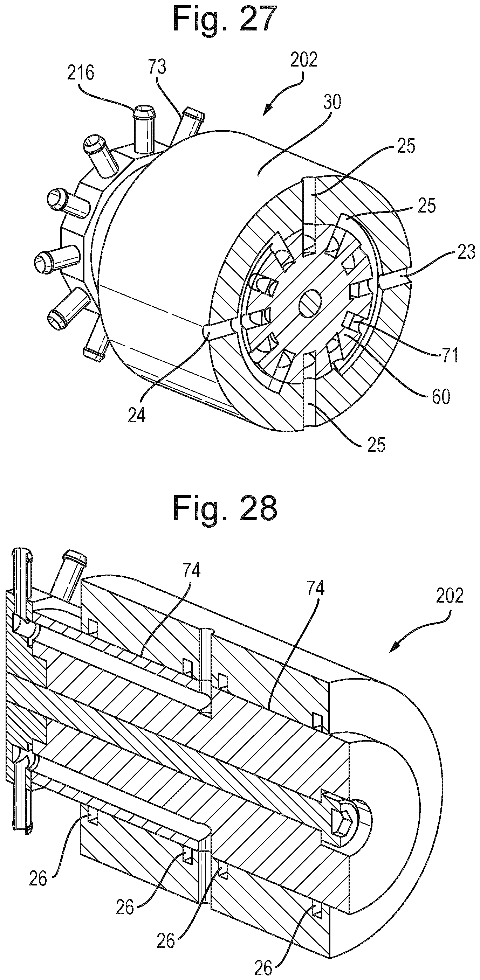

Figure 27 schematically depicts a perspective view of the stage 202 shown in Figure 26. As shown in Figure 26 and Figure 27, in an embodiment the stage 202 comprises a clamping supply 23. The clamping supply 23 is configured to supply a clamping pressure (e.g. vacuum pressure) and/or a clamping potential (in the case of electrostatic clamping). As shown in Figure 26 and Figure 27, in an embodiment the clamping supply 23 is in communication with a plurality of the feed through channels (i.e. fluid channel 71 or electrical transmission lines) at any one time. In the arrangement shown in Figure 26 and Figure 27, the clamping supply 23 is in communication with five of the feedthrough channels. As shown in Figure 26 and Figure 27, in an embodiment the support member 30 comprises the clamping supply 23. Alternatively, the clamping supply 23 may be external to the support member 30. As shown in Figure 26 and Figure 27, in an embodiment the stage 202 comprises a connecting conduit 25 configured to connect a plurality of the feedthrough channels to the common clamping supply 23.

In an embodiment the clamping supply 23 is configured to supply a constant clamping level. For example, the clamping supply 23 may be configured to supply a substantially constant vacuum pressure to the plurality of feedthrough channels. Alternatively, the clamping supply 23 may be configured to supply a substantially constant electrical potential to a plurality of electrical transmission lines.

As the feedthrough member 60 rotates relative to the support member 30, the identity of the feedthrough channels that are in communication with the clamping supply 23 changes.

As shown in Figure 26 and Figure 27, in an embodiment the stage 202 comprises a non-clamping supply 24. For example, in the context of pneumatic clamping the non-clamping supply 24 may be configured to supply ambient pressure to a plurality of fluid conduits 71. As shown in Figure 26, in an embodiment a plurality of the feedthrough channels are in communication with the non-clamping supply 24 at any one time. In the arrangement shown in Figure 26, five of the fluid conduits 71 are in communication with the non-clamping supply 24 via a connecting conduit 25.

As shown in Figure 26, the feedthrough member 60 rotates clockwise in the orientation shown in Figure 26 relative to the support member 30. As the feedthrough member 60 rotates, each fluid conduit 71 varies between being connected to the upper clamp controller 21, the clamping supply 23, the lower clamping controller 22 and the non-clamping supply 24.

Figure 28 is a cross-sectional view of the stage 202 shown in Figure 27. As shown in Figure 28, in an embodiment the feedthrough member 60 is configured with a gas bearing 74 relative to the support member 30. The gas bearing 74 is configured to support the feedthrough member 60. It is not essential for a gas bearing 74 to be provided. For example, other types of bearing can be used as well or alternatively.

As shown in Figure 28, in an embodiment the gas bearing 74 is provided at both sides of the feedthrough channels. That is, a first gas bearing 74 is provided axially between the clamping supply 23 and the movable member 20. A second gas bearing 74 is located such that the clamping supply 23 is located axially between the second gas bearing 74 and the movable member 20. However, it is not essential for gas bearings 74 to be provided at both sides of the feedthrough channels. In an alternative arrangement, the gas bearing 74 may be at a single side of the feedthrough channels.

As shown in Figure 28, in an embodiment the stage 202 comprises one or more ambient pressure grooves 26 configured to allow for the flow of gas that forms the gas bearing 74. In an embodiment the ambient pressure grooves 26 are formed substantially annularly within the support member 30. By providing a gas bearing, the bearing gap may be reduced. By using a gas bearing, the possibility of particles being undesirably generated by friction is reduced. In an alternative embodiment the gas bearing is replaced with another type of bearing such as a roller bearing.

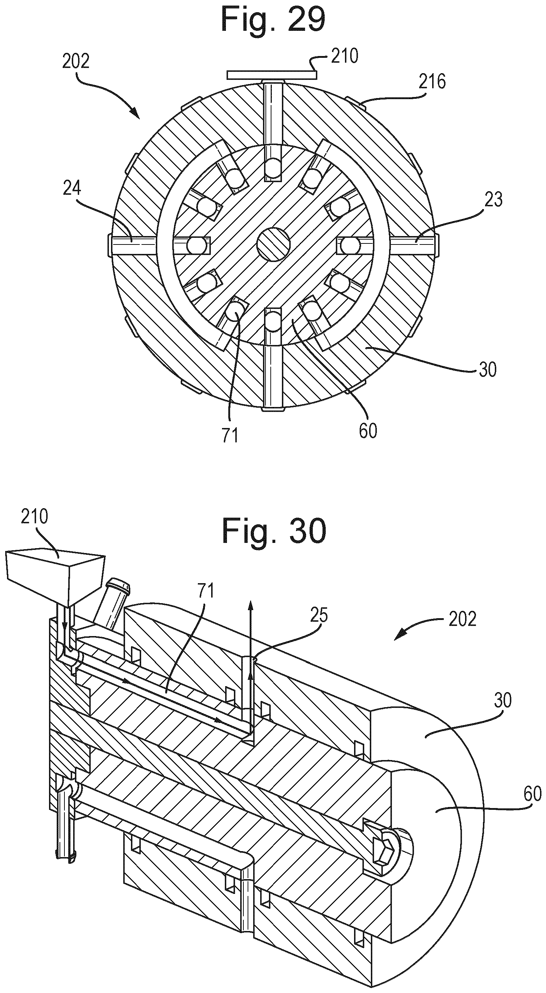

Figure 29 schematically depicts the stage 202 shown in Figure 26 holding a die 210 at its upper side. Figure 29 shows a first die 210 placed on top of the movable member 20. During use of the stage 202, a clamping level is applied to the upper die 210. For example, a vacuum may be applied to the upper channel via the upper clamping controller 21.

Figure 30 schematically depicts a cross-sectional perspective view of the stage 202 shown in Figure 29. In Figure 30, the flow of gas through the fluid conduit 71 at the upper side of the stage 202 is shown by the extended arrow.

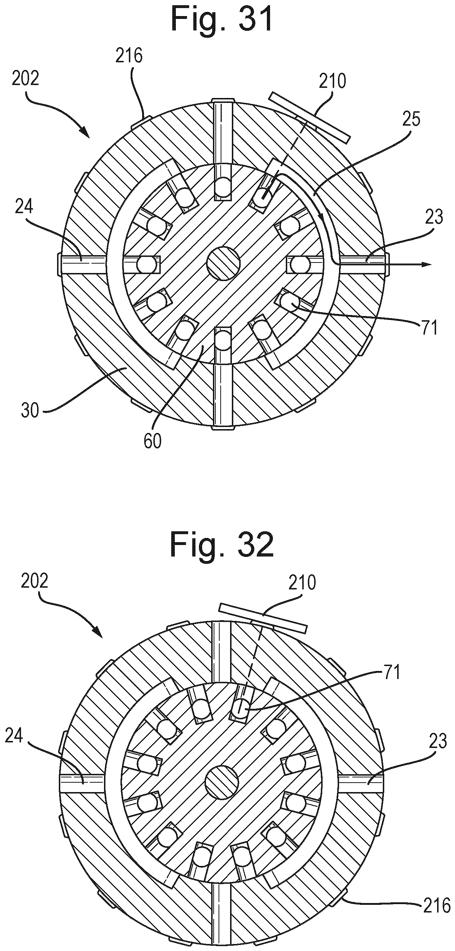

Figure 31 schematically depicts the stage 202 shown in Figure 29 at a later point in time. In the orientation shown in Figure 31, the movable member 20 (on which the die 210 is held) together with the feedthrough member 60 have rotated clockwise by 30° relative to the support member 30. In other words, in Figure 31, the movable member 20 is rotated to the next station relative to the position shown in Figure 29. As a result of the rotation of the feedthrough member 60, the clamping channel for the die 210 is connected to the clamping supply 23 via the connecting conduit 25. The flow of gas through the connecting conduit 25 and the clamping supply 23 is shown by the arrow in Figure 31.

As the feedthrough member 60 rotates over the next 120° (i.e. over the next four stations), the clamping level applied to the die 210 is the same as the clamping level applied to for the other feedthrough channels. That is, the clamping level of a plurality of the dies 210 is controlled in common. An embodiment of the invention is expected to simplify the clamping feedthrough. There is no need to switch every feedthrough channel on or off independently at any time. In the arrangement shown in Figure 26, for example, the feedthrough channel for the upper die 210 can be controlled independently. Similarly, the feedthrough channel for the lower die 210 can be controlled independently. Clamping for other dies are not required to be controlled independently. For the upper die 210 on the top of the movable member 20, a new donor die is supplied to the movable member 20. Accordingly, clamping is required to be controlled in order to control holding of a new die 210. At the lower position, a donor die is placed on the acceptor substrate. The unclamping of the die may be controlled at this point. However, at other points there is not required to be a change in the state of the clamping. An embodiment of the invention is expected to reduce the volume required for providing a feedthrough for operating multiple die clamps.

Figure 32 schematically depicts the stage 202 shown in Figure 26 at an intermediate point in time between that shown in Figure 29 and that shown in Figure 31. During rotation between the position shown in Figure 29 and the position shown in Figure 31, the fluid channel 71 is not connected to either the clamping supply 23 or the upper clamp controller 21. The fluid channel 71 is effectively closed. When the fluid channel 71 is effectively closed, the clamping level may be expected to decrease gradually. In an embodiment the rotation of the feedthrough member 60 relative to the support member 30 is sufficiently quick that the die 210 remains clamped between the upper clamp controller 21 and the clamping supply 23.

As shown in Figure 26, for example, in an embodiment the feedthrough member 60 is configured such that the electrical transmission lines and/or the fluid conduits 71 remain connected to the clamping supply 23 during most of the die path. That is, for most of the rotation of the feedthrough member 60 for a 180° rotation relative to the support member 30, a fluid channel 71 remains in communication with the clamping supply 23. This reduces the complexity of the clamping feedthrough. By reducing the complexity, the lifetime of the apparatus may be increased. An embodiment of the invention is expected to reduce the number of components required. By reducing the number of components, the possibility of a component requiring replacement may be reduced.

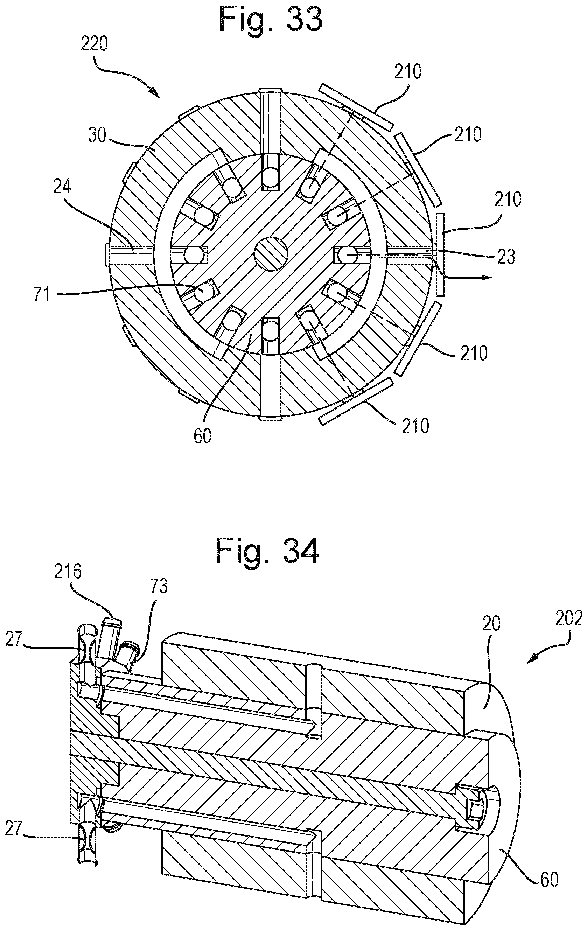

Figure 33 schematically depicts the stage 202 when it is holding a plurality of dies 210. As shown in Figure 33, during use of the stage 202, dies 210 may be provided on substantially all of the die acceptors 216 in the path from the upper side to the lower side of the stage 202.

The dies 210 may block one end of the feedthrough channels. That is, the dies 210 may prevent flow of gas at the die acceptor end of the feedthrough channels. When the dies 210 are held by the die acceptors 216, the vacuum pressure can be maintained, with low flow.

Figure 34 schematically depicts a cross-sectional view of an optional feature of the stage 202. As shown in Figure 34, in an embodiment the movable member 20 comprises flow restrictions 27. The flow restrictions 27 may be adjacent to where dies 210 are held by the movable member 20. In particular the flow restrictions 27 may be adjacent to the die acceptors 216. The die acceptors 216 form the ends of the feedthrough channels.

In an embodiment a flow restriction 27 is integrated in all die clamp channels. By providing the flow restrictions 27, the possibility of undesirable gas flow into the feedthrough channels where the die acceptor ends may be reduced. An embodiment of the invention is expected to make it easier for clamping level to be maintained for the die clamp channels.

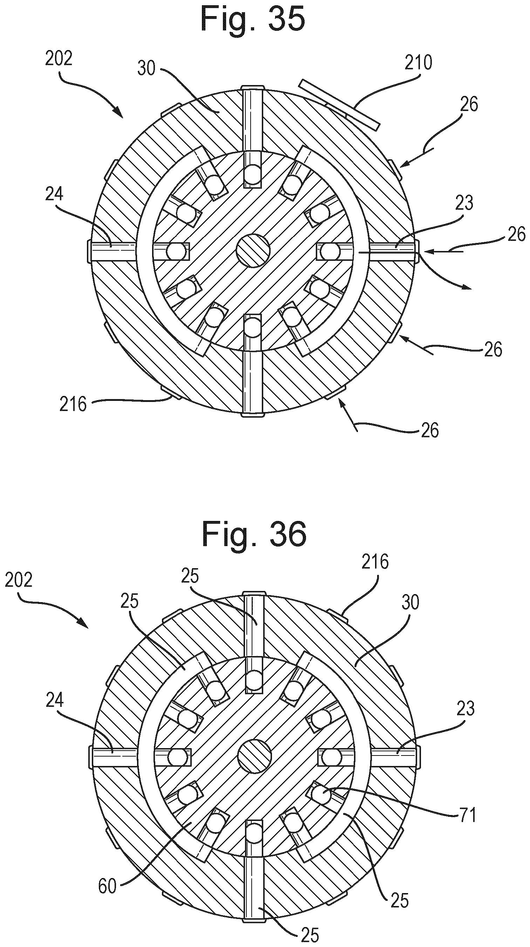

Figure 35 schematically depicts an arrangement in which only one die 210 is held by the movable member 20. In the orientation shown in Figure 35, four of the feedthrough channels in communication with the clamping supply 23 have no die 210 held. As a result, there may be an in-leak 28 into the feedthrough channels. By providing the flow restrictions 27, such in-leak may be reduced.

Figure 36 schematically depicts an alternative stage 202 in which the non-clamping supply 24 shown in Figure 26 is replaced with a clamping supply 23. As shown in Figure 36, in an embodiment the stage 202 comprises a plurality of clamping supplies 23. By providing the additional clamping supply 23, the time taken to clamp a die 210 may be reduced.

As a further alternative, there may be no clamping supply 23 or non-clamping supply 24 provided on the left hand side of Figure 36.

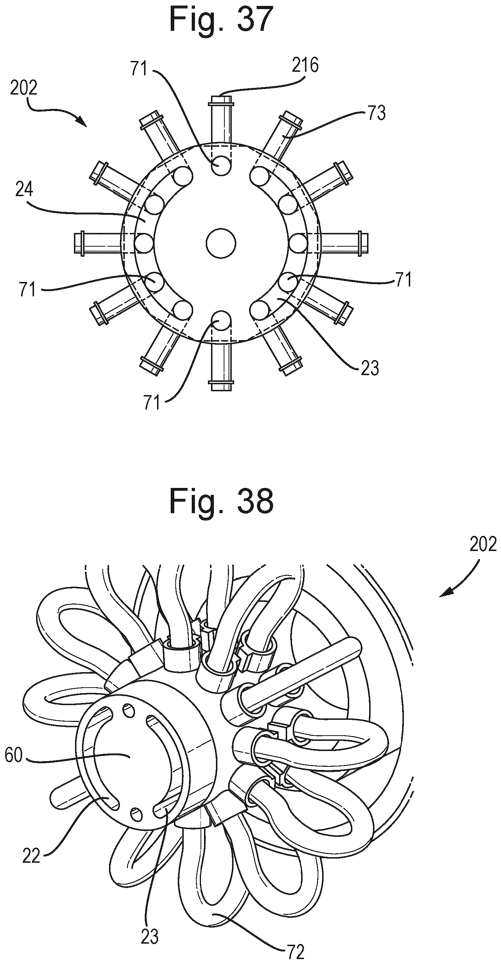

In the arrangements shown in Figure 26 and Figure 36, for example, the fluid channels 71 are in communication with the upper clamp controller 21, the lower clamp controller 22, the clamping supply 23 and the non-clamping supply 24 via radial conduits (e.g. connecting conduits 25). However, it is not essential for the feedthrough to be radial. In an alternative embodiment, the feedthrough can be axial. For example, Figure 37 schematically depicts an alternative stage 202 in which axial channels are used for connecting to the fluid conduits 71. Figure 38 is a perspective view of the stage 202 shown in Figure 37.

In Figures 26-38, the feedthrough channels are described primarily in the context of pneumatic clamping. Alternatively, the clamping may be electrostatic or piezoelectric, in which case the fluid channels are replaced by electrical transmission lines. In an alternative arrangement, both pneumatic clamping and electrostatic/piezoelectric clamping may be used, in which case each die acceptor 216 may be provided with a corresponding electrical transmission line and a corresponding fluid conduit 71.

Further embodiments of the invention are disclosed in the list of numbered clauses below:
1. A stage for die placement comprising: a support member; a movable member that is movable relative to the support member, wherein the movable member is configured to hold at least one die; and an actuator configured, on actuation, to move the movable member relative to the support member so as to flip the die and move the die along a die path to place the die on an acceptor substrate, wherein the stage is arranged such that the die path extends further in a direction perpendicular to a plane of the acceptor substrate than in a direction parallel to the plane of the acceptor substrate.
2. The stage of clause 1, wherein the movable member is configured to rotate about an axis substantially parallel to the plane of the acceptor substrate so as to flip the die while moving the die in the direction perpendicular to the plane of the acceptor substrate.
3. The stage of clause 2, wherein the movable member is configured to rotate in both directions about the axis substantially parallel to the plane of the acceptor substrate.
4. The stage of clause 3, configured to: move a first die along the die path including rotating the movable member in a first direction about the axis substantially parallel to the plane of the acceptor substrate to place the first die on the acceptor substrate, and move a second die along a second die path including rotating the movable member in a second direction opposite to the first direction about the axis substantially parallel to the plane of the acceptor substrate to place the second die on the acceptor substrate.
5. The stage of any preceding clause, configured such that at least part of the movable member is configured to move relative to the support member in the direction perpendicular to the plane of the acceptor substrate so as to place the die onto the acceptor substrate.
6. The stage of any preceding clause, comprising: a balance mass configured to move relative to the support member so as to reduce torque exerted by the stage during use of the stage.
7. The stage of clause 6, wherein the balance mass is configured to move relative to the support member in a direction opposite to a direction in which the movable member is moving relative to the support member.
8. The stage of clause 6 or 7, comprising: an anti-drift mechanism configured to reduce drifting of a speed of movement of the balance mass relative to the support member.
9. The stage of clause 8, wherein the anti-drift mechanism comprises: a torsional spring and/or a rotary motor configured to apply a force to the balance mass.
10. The stage of any preceding clause, wherein the movable member comprises at least one die acceptor configured to hold a die.
11. The stage of clause 10, wherein the die acceptor protrudes between the die held by the die acceptor and a gap for accommodating an external component.
12. The stage of clause 10 or 11, wherein a pair of die acceptors are provided on opposing protruding arms of the movable member.
13. The stage of clause 12, wherein the movable member comprises a shaft configured to support the protruding arms and to rotate relative to the support member.
14. The stage of clause 13, wherein the shaft is movable relative to the support member in a direction radial to an axis of the shaft.
15. The stage of clause 13 or 14, wherein the protruding arms are configured to move relative to the shaft in a direction radial to an axis of the shaft.
16. The stage of clause 15, wherein the movable member comprises a spring configured to at least partly compensate for a centrifugal force associated with the protruding arms during rotation of the shaft.
17. The stage of clause 15 or 16, wherein the protruding arms are fixed relative to each other such that the protruding arms are configured to move together relative to the shaft.
18. The stage of any of clauses 15-17, comprising a placement actuator configured, on actuation, to move the protruding arms.
19. The stage of clause 18, wherein the placement actuator is a Lorentz force actuator comprising coils in the support member and magnets fixed relative to the protruding arms.
20. The stage of any of clauses 15-19, wherein the movable member comprises a double parallel leaf spring guide connecting the shaft to the protruding arms via an intermediate body.
21. The stage of clause 20, comprising lever flexures angled relative to each other so as to form a virtual hinge between the intermediate body and the protruding arms.
22. The stage of any preceding clause, comprising at least one electrical transmission line and/or at least one fluid conduit extending between the support member and the movable member and configured to flex during movement of the movable member relative to the support member.
23. The stage of any preceding clause, comprising: a feedthrough member configured to rotate together with the movable member relative to the support member, wherein the feedthrough member comprises at least one electrical transmission line and/or at least one fluid conduit.
24. The stage of clause 23, comprising at least one electrical transmission line and/or at least one fluid conduit extending between the feedthrough member and the movable member and configured to flex during movement of the movable member relative to the support member.
25. The stage of clause 23 or 24, wherein the feedthrough member is configured such that at least one electrical transmission line and/or at least one fluid conduit remains connected between the feedthrough member and the support member during rotation of the feedthrough member relative to the support member.
26. The stage of any of clauses 23-25, wherein the feedthrough member comprises a stroke limiter configured to limit a stroke of the movable member relative to the feedthrough member.
27. The stage of any of clauses 23-26, wherein the feedthrough member is coupled to the support member via a gas bearing.
28. The stage of clause 27, wherein the support member comprises a gas extractor configured to extract gas from a location between a gas supply of the gas bearing and the movable member.
29. The stage of any of clauses 23-27, wherein the feedthrough member comprises a plurality of electrical transmission lines and/or a plurality of fluid conduits for controlling clamping of respective dies.
30. The stage of clause 29, comprising: an upper clamp controller configured to control clamping of a die held at an upper side of the movable member via the corresponding electrical transmission line and/or fluid conduit; and/or a lower clamp controller configured to control clamping of a die held at a lower side of the movable member via the corresponding electrical transmission line and/or fluid conduit.
31. The stage of clause 30, wherein: the upper clamp controller is configured to be in communication with a die held by the movable member only when the die is at the upper side of the movable member; and/or the lower clamp controller is configured to be in communication with a die held by the movable member only when the die is at the lower side of the movable member.
32. The stage of any of clauses 29-31, comprising a clamping supply configured to supply a clamping potential to a plurality of the electrical transmission lines and/or a clamping pressure to a plurality of the fluid conduits.
33. The stage of clause 32, wherein the feedthrough member is configured such that the electrical transmission lines and/or the fluid conduits remain connected to the clamping supply during most of the die path.
34. The stage of any of clauses 29-33, wherein the movable member comprises flow restrictions adjacent to where dies are held by the movable member.
35. A bonding tool comprising: the stage of any preceding clause.
36. The bonding tool of clause 35, comprising: a support structure configured to support the acceptor substrate on a support surface.
37. The bonding tool of clause 35 or 36, wherein the support surface of the support structure faces the stage for die placement.
38. The bonding tool of clauses 36 or 37, wherein the stage for die placement overlaps the support structure when viewed in a direction perpendicularly to the support surface of the support structure.
39. The bonding tool of any of clauses 35-38, comprising a location measurement element configured to measure a location of the die when the die is on the die path.
40. The bonding tool of any of clauses 35-39, comprising: a conveyor belt configured to convey dies in a direction substantially parallel to the plane of the acceptor substrate towards the acceptor substrate.
41. The bonding tool of clause 40, wherein the conveyor belt comprises burls having distal ends arranged in a plane for supporting the dies.
42. The bonding tool of clause 40 or 41, wherein the conveyor belt comprises apertures for applying an underpressure to clamp the dies onto the conveyor belt.
43. A method for die placement comprising: actuating an actuator to move a movable member relative to a support member so as to flip a die held by the movable member and move the die along a die path to place the die on an acceptor substrate, wherein the die path extends further in a direction perpendicular to a plane of the acceptor substrate than in a direction parallel to the plane of the acceptor substrate.
44. The method of clause 43, comprising: while placing a first die onto the acceptor substrate, placing a second die on another part of the movable member.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A stage for die placement comprising:
a support member;
a movable member that is movable relative to the support member, wherein the movable member is configured to hold at least one die; and
an actuator configured, on actuation, to move the movable member relative to the support member so as to flip the die and move the die along a die path to place the die on an acceptor substrate,
wherein the stage is arranged such that the die path extends further in a direction perpendicular to a plane of the acceptor substrate than in a direction parallel to the plane of the acceptor substrate.

2. The stage of claim 1, wherein the movable member is configured to rotate about an axis substantially parallel to the plane of the acceptor substrate so as to flip the die while moving the die in the direction perpendicular to the plane of the acceptor substrate.

3. The stage of claim 2, wherein the movable member is configured to rotate in both directions about the axis substantially parallel to the plane of the acceptor substrate.

4. The stage of claim 3, configured to:
move a first die along the die path including rotating the movable member in a first direction about the axis substantially parallel to the plane of the acceptor substrate to place the first die on the acceptor substrate, and
move a second die along a second die path including rotating the movable member in a second direction opposite to the first direction about the axis substantially parallel to the plane of the acceptor substrate to place the second die on the acceptor substrate.

5. The stage of claim 1, configured such that at least part of the movable member is configured to move relative to the support member in the direction perpendicular to the plane of the acceptor substrate so as to place the die onto the acceptor substrate.

6. The stage of claim 1, comprising:
a balance mass configured to move relative to the support member so as to reduce torque exerted by the stage during use of the stage.

7. The stage of claim 6, wherein the balance mass is configured to move relative to the support member in a direction opposite to a direction in which the movable member is moving relative to the support member.

8. The stage of claim 6 or 7, comprising:
an anti-drift mechanism configured to reduce drifting of a speed of movement of the balance mass relative to the support member.

9. The stage of claim 8, wherein the anti-drift mechanism comprises:
a torsional spring and/or a rotary motor configured to apply a force to the balance mass.

10. The stage of claim 1, comprising:
a feedthrough member configured to rotate together with the movable member relative to the support member, wherein the feedthrough member comprises at least one electrical transmission line and/or at least one fluid conduit.

11. The stage of claim 10, wherein the feedthrough member is configured such that at least one electrical transmission line and/or at least one fluid conduit remains connected between the feedthrough member and the support member during rotation of the feedthrough member relative to the support member.

12. A bonding tool comprising the stage of claim 1.

13. The bonding tool of claim 12, comprising:
a conveyor belt configured to convey dies in a direction substantially parallel to the plane of the acceptor substrate towards the acceptor substrate.

14. The bonding tool of claim 13, wherein the conveyor belt comprises burls having distal ends arranged in a plane for supporting the dies.

15. The bonding tool of claim 13, wherein the conveyor belt comprises apertures for applying an underpressure to clamp the dies onto the conveyor belt.
